# EUROPEAN PATENT APPLICATION

(11) **EP 4 492 457 A1**
(43) Date of publication of application: **15.01.2025**
(21) Application number: 23184790.6
(22) Date of filing: 11.07.2023
(51) Int. Cl.: H01L 23/492, H01L 23/495, H01L 25/11

(54) **SEMICONDUCTOR MODULE**

(71) Applicant: Infineon Technologies Austria AG, 9500 Villach (AT)
(72) Inventor: SCHARF, Thorsten, 93138 Lappersdorf (DE); YUFEREV, Sergey, 9500 Villach (AT)
(74) Representative: Infineon Patent Department

(57) **Abstract**

In an embodiment, a semiconductor module is provided that comprises first and second semiconductor packages. Each of the first and second semiconductor packages comprises a semiconductor die comprising opposing first and second main surfaces, a source pad and a gate pad on the first main surface and a drain pad on the second main surface, a first lead and a second lead. The first lead comprises an inner surface, an outer surface that opposes the inner surface and a contact surface extending between the inner and outer surfaces. The inner surface of the first lead is attached to the source pad and the contact surface of the first lead extends substantially perpendicularly to the first main surface of the semiconductor die. The second lead comprises an inner surface, an outer surface that opposes the inner surface and a contact surface extending between the inner and outer surfaces. The inner surface of the second lead is attached to the drain pad and the contact surface of the second lead extends substantially perpendicularly to the first main surface of the semiconductor die. The contact surfaces of the first and second leads are located in a contact plane and each provide a contact surface of the semiconductor module. The outer surface of the second lead of the first semiconductor package is attached and electrically connected to the outer surface of the second lead of the second semiconductor package.

## Description

### BACKGROUND

A semiconductor package includes one or more semiconductor devices and may include a substrate or a leadframe which includes outer contacts which are used to mount the package on a redistribution board such as a printed circuit board. The package also includes internal electrical connections from the semiconductor device to the substrate or leadframe and a housing. The housing may be formed of a plastic molding compound which covers the semiconductor device and the internal electrical connections. Published US patent application US 2004/0212057 A1 describes a semiconductor component having a housing and at least two semiconductor chips in the housing and at least one contact clip which projects from the housing.

Semiconductor packages which occupy a smaller area when mounted on a higher-level board, such as a circuit board, are desirable.

### SUMMARY

In an exemplary embodiment, a semiconductor module is provided that comprises a semiconductor package and an electrically conductive plate. The electrically conductive plate comprises a first main surface, a second main surface opposing the first main surface and a contact surface. The semiconductor package comprises a semiconductor die comprising opposing first and second main surfaces, a first power pad on the first main surface and a second power pad on the second main surface. The semiconductor package further comprises a first lead comprising an inner surface, an outer surface that opposes the inner surface and at least one contact surface. The inner surface of the first lead is attached to the first power pad of the semiconductor die and the at least one contact surface of the first lead extends substantially perpendicularly to the first main surface of the semiconductor die. The semiconductor package further comprises a second lead comprising an inner surface that is attached to the second power pad of the semiconductor die and an outer surface that opposes the inner surface of the second lead. A mold compound encloses at least part of the semiconductor die and at least part of the first and second leads. The outer surface of the second lead is exposed from the mold compound and the first main surface of the plate is attached to the outer surface of the second lead. The contact surface of the plate extends substantially perpendicularly to the second main surface of the semiconductor die. The at least one contact surface of the first lead and the contact surface of the plate are located in a contact plane and each provide a contact surface of the semiconductor module.

The semiconductor module is vertically mountable on a higher-level board, e.g. a circuit board, such that the first and second main surfaces of the semiconductor die are orientated perpendicularly to the main surface of the board, as the at least one contact surface of the first lead and the contact surface of the plate are located in a contact plane that is perpendicular to the first and second main surfaces of the semiconductor die.

Since the first main surface of the plate is attached to the outer surface of the second lead, the outer surface of the second lead is exposed from the mold compound.

The semiconductor die is located between the first and second leads within the semiconductor package in a stacked or sandwich arrangement with the stacking direction being substantially parallel to the contact plane.

In some embodiments, the semiconductor die comprises a diode and the first power pad is an anode pad and the second power pad is a cathode pad. In some embodiments, the semiconductor die comprises a transistor device. As the first and second power pads are arranged on the opposing first and second main surfaces of the semiconductor die, the diode or transistor device may be referred to as a "vertical" device and the drift path extends perpendicularly to the first and second main surface of the semiconductor die.

In some embodiments in which the semiconductor die comprises a transistor device, the first power pad is a source pad, the second power pad is a drain pad and a gate pad is arranged on the first main surface of the semiconductor die.

In some embodiments, the transistor device is a MOSFET (Metal Oxide Semiconductor Field Effect Transistor) device, an insulated gate bipolar transistor (IGBT) device or a Bipolar Junction Transistor (BJT).

In some embodiments, the second lead is spaced at a distance from the contact plane. The second lead has a first or lower side face that extends between the inner and outer surface and that faces towards the contact plane and a second or upper side face that extends between the inner and outer surface and that faces away from the contact plane. This first side face is spaced apart from the contact plane. The distance or gap between the second lead and the contact plane is bridged by the electrically conductive plate.

In some embodiments, the second lead is devoid of contact surfaces of the module. In these embodiments, the second lead forms part of the internal connection structure of the semiconductor module only.

In some embodiments, the inner surface of the first lead that is unoccupied by the semiconductor die is covered by the mold compound. Additionally, the outer surface of the first lead may be covered by the mold compound. In some embodiments, the inner surface of the second lead that is unoccupied by the semiconductor die is covered by the mold compound. The periphery of the semiconductor die that is not in contact with the first and second leads may be covered by the mold compound.

In some embodiments, the first lead is a contact clip and extends into two or more legs, each leg comprising one contact surface of the lead, whereby this contact surface extends substantially perpendicularly to the first main surface of the semiconductor die. The contact clip comprises a die support section which provides the inner surface that is attached to the first power pad and the two or more legs are integral with the die support section of the contact clip.

In some embodiments, the or each leg is bent to form a foot that extends away from the first main surface of the semiconductor die. Each leg may be considered to have a L-shape in a cross-sectional view. The foot has a lower surface that forms the contact surface of the first lead. The contact surface of the plate extends between the first and second main surfaces of the plate. The plate may have a substantially planar shape and be without a bent foot.

In some embodiments, one or both of the first lead and the plate are bent to form a foot.

In some embodiments, the first lead is bent to form a foot that extends away from the first main surface of the semiconductor die, a base of the foot providing the contact surface of the first lead, and the contact surface of the plate extends between the first and second main surfaces of the plate.

In some embodiments, the plate is bent to form a foot that extends away from the second main surface of the semiconductor die and the base of the foot of the plate provides the contact surface of the plate. The contact surface of the first lead is provided by the side face of the first lead that extends between the inner and outer surfaces of the first lead.

In some embodiments, both the first lead and the plate are bent to form a foot that extends away from the first main surface and the second main surface of the semiconductor die respectively. The foot of the first lead and the foot of the plate extend in opposing directions. A base of the foot of the first lead provides the contact surface of the first lead and the base of the foot of the plate provides the contact surface of the plate.

The first lead and the second lead may be substantially planar. The plate may also be substantially planar. In some embodiments, the first lead comprises a foot that extends away from the first main surface of the semiconductor die. Each leg may be considered to have a L-shape in a cross-sectional view. The foot has a lower surface that forms the contact surface of the first lead. The contact surface of the plate extends between the first and second main surfaces of the plate. The plate may have a substantially planar shape and be without a foot.

In some embodiments, the semiconductor module further comprises a third lead comprising an inner surface that is attached to a control pad, e.g. a gate pad, of the semiconductor die and a contact surface that extends substantially perpendicularly to the first main surface of the semiconductor die. The contact surface of the third lead is located in the contact plane.

In some embodiments, the third lead is substantially planar. The third lead may be substantially planar if the first lead is substantially planar. In these embodiments, the contact surface extends between the inner and outer surfaces of the respective lead. In some embodiments, the third lead has a foot extends perpendicularly to a control pad contact portion and perpendicularly to the first man surface of the semiconductor die and has a lower surface forming the contact surface that is located in the contact plane. The third lead may be bent to form a foot. The third lead may have a foot form if the first lead has a foot form.

In some embodiments, the first lead is U-shaped in plan view, e.g. the inner and outer surfaces have a U-shape, and the third lead is surrounded on three sides by the first lead.

In some embodiments, the first lead is L-shaped in plan view, e.g. the inner and outer surfaces have a L-shape, and the third lead is located in a corner of the first main surface of the semiconductor die.

In some embodiments, the plate extends over and protrudes above the second side face of the second lead that opposes the contact plane. The section of the plate that protrudes above the side face of the second lead that opposes the contact plane may serve as a heat dissipator for dissipating heat from the module.

In some embodiments, one or more side faces of the second lead, e.g. the side face facing towards or away from the contact plane, comprises at least one portion that is exposed from the mold compound. This arrangement may be used if the semiconductor package has a standard outline and is surface mountable such that these exposed portions can provide contact surfaces if the package is mounted on a board such that the first and second main surfaces of the semiconductor die are substantially parallel to the main surface of the circuit board. In contrast, in the module, the first and second main surfaces of the semiconductor die are substantially perpendicular as is the case when the semiconductor module described herein including this package is vertically mounted on the main surface of a circuit board.

In some embodiments, the first lead is attached and electrically connected to the first power pad by a die attach material and the second lead is attached and electrically connected to the second power pad by a die attach material. The plate may also be attached and electrically connected to the outer surface of the second lead by a die attach material. If a third lead is used, the third lead may be attached and electrically connected to the control pad by a die attach material. The die attach material may be a soft solder, electrically conductive adhesive or a diffusion solder. The plate may be attached to the second lead using the same die attach material, e.g. soft solder. In some embodiments, the plate is attached to the second lead using a different die attach material compared to the die attach material used within the semiconductor package, i.e. between the leads and the die. For example, the die attach material within the package may be soft solder and the die attach material used to attach the plate to the second lead may be electrically conducive adhesive.

In some embodiments, the semiconductor module according to any one of the embodiments described above further comprises a further semiconductor package.

In some embodiments, the further semiconductor package has the same structure as the semiconductor package of the module.

In some embodiments, the further semiconductor package comprises a semiconductor die comprising opposing first and second main surfaces, a first power pad on the first main surface and a second power pad on the second main surface, a first lead comprising an inner surface, an outer surface that opposes the inner surface and at least one first contact surface, wherein the inner surface is attached to the first power pad and the at least one first contact surface extends substantially perpendicularly to the first main surface of the semiconductor die, a second lead comprising an inner surface that is attached to the second power pad and an outer surface that opposes the inner surface and a mold compound enclosing at least part of the semiconductor die and at least part of the first and second leads. The outer surface of the second lead of the further semiconductor package is attached to the second main surface of the plate.

The further semiconductor package may have the same structure as the semiconductor package of any one of the embodiments described herein.

In some embodiments, both semiconductor packages comprise a semiconductor die comprising a transistor device. In some embodiments, the transistor device is a MOSFET (Metal Oxide Semiconductor Field Effect Transistor) device, an insulated gate bipolar transistor (IGBT) device or a Bipolar Junction Transistor (BJT).

In some embodiments, the first power pad of the further semiconductor package is a source pad and the second power pad of the further semiconductor package is a drain pad. A control pad, e.g. a gate pad may also be located on the first main surface of the semiconductor die of the further semiconductor package.

In some embodiments, the drain pad of the semiconductor package and the drain pad of the further semiconductor package are electrically connected to the plate. When the module is mounted on a higher-level circuit board, the drain pad of the semiconductor package and the drain pad of the second semiconductor package are electrically connected in series with one another. In some embodiments, the plate is devoid of a contact surface of the module and provides an internal connection of the module only.

In some embodiments, the semiconductor package and the further semiconductor package have a mirror symmetrical arrangement about a central plane of the plate that extends parallel to the first and second main surfaces of the respective semiconductor dies.

In some embodiments, both semiconductor packages include a third lead. For example, both semiconductor packages comprise a semiconductor die comprising a transistor device. The third lead of the semiconductor package and the third lead of the further semiconductor package may be arranged at opposing corners of the contact plane. In some embodiments, the third lead of the semiconductor package and the third lead of the further semiconductor package have a mirror symmetrical arrangement about the central plane of the plate that extends parallel to the first and second main surfaces of the respective semiconductor dies.

In other embodiments, the third lead of the semiconductor package and the third lead of the further semiconductor package are located at diagonally opposing corners of the contact plane. In these embodiments, the module may be rotationally symmetric about an axis extending parallel to the first and second main surfaces of the semiconductor dies.

The third lead may be connected to a control pad that is arranged at a corner of the first main surface of the semiconductor die of the respective one of the semiconductor package and further semiconductor package. The control pads may be arranged at diagonally opposing corners of the respective one of the semiconductor package and further semiconductor package, or have a mirror symmetrical arrangement about the central plane of the plate that extends parallel to the first and second main surfaces of the respective semiconductor dies.

In an exemplary embodiment, a semiconductor module is provided that comprises first and second semiconductor packages. Each of the first and second semiconductor packages comprises a semiconductor die comprising opposing first and second main surfaces, a source pad and a gate pad on the first main surface and a drain pad on the second main surface, a first lead and a second lead. The first lead comprises an inner surface, an outer surface that opposes the inner surface and a contact surface extending between the inner and outer surfaces. The inner surface of the first lead is attached to the source pad and the contact surface of the first lead extends substantially perpendicularly to the first main surface of the semiconductor die. The second lead comprises an inner surface, an outer surface that opposes the inner surface and a contact surface extending between the inner and outer surfaces. The inner surface of the second lead is attached to the drain pad and the contact surface of the second lead extends substantially perpendicularly to the first main surface of the semiconductor die. The contact surfaces of the first and second leads are located in a contact plane and each provide a contact surface of the semiconductor module. The outer surface of the second lead of the first semiconductor package is attached and electrically connected to the outer surface of the second lead of the second semiconductor package.

Each of the first and second semiconductor packages of this module may have the same structure and may have the structure of the semiconductor package according to any one of the embodiments described herein.

The semiconductor module is vertically mountable on a higher-level board, e.g. a circuit board, such that the first and second main surfaces of the semiconductor die are orientated perpendicularly to the main surface of the board as the contact surfaces of the first and second leads of each of the first and second package extend perpendicularly tot eh first main surface of the semiconductor die of that package.

In some embodiments, the first power pad of the first and second semiconductor package is a source pad and the second power pad of the first and second semiconductor package is a drain pad. A control pad, e.g. a gate pad may also be located on the first main surface of the semiconductor die of the first and second semiconductor package.

In some embodiments, the drain pad of the first semiconductor package and the drain pad of the second semiconductor package are electrically connected to one another. When the module is mounted on a higher-level circuit board, the drain pad of the first semiconductor package and the drain pad of the second semiconductor package are electrically connected in series with one another.

In some embodiments, the first semiconductor package and the second semiconductor package have a mirror symmetrical arrangement about a central plane of the module that extends parallel to the first and second main surfaces of the semiconductor dies.

In some embodiments, both semiconductor packages include a third lead. For example, both the first and second semiconductor packages comprise a semiconductor die comprising a transistor device. The third lead of the first semiconductor package and the third lead of the second semiconductor package may arranged at opposing corners of the contact plane. In some embodiments, the third lead of the first semiconductor package and the third lead of the second semiconductor package have a mirror symmetrical arrangement about the central plane of the plate that extends parallel to the first and second main surfaces of the respective semiconductor dies.

In other embodiments, the third lead of the first semiconductor package and the third lead of the second semiconductor package are located at diagonally opposing corners of the contact plane. In these embodiments, the module may be rotationally symmetric about an axis extending parallel to the first and second main surfaces of the semiconductor dies.

The third lead may be connected to a control pad that is arranged at a corner of the first main surface of the semiconductor die of the respective one of the first semiconductor package and second semiconductor package. The control pads may be arranged at diagonally opposing corners of the contact plane, or have a mirror symmetrical arrangement about the central plane of the module that extends parallel to the first and second main surfaces of the respective semiconductor dies.

In some embodiments, the semiconductor further comprises an additional electrically conductive plate that is positioned between the first and second packages. The additional plate is used to attach and electrically connect the outer surface of the second lead of the first semiconductor package to the outer surface of the second lead of the second semiconductor package. The additional p plate may be attached and electrically connected to the outer surface of the second lead of the first semiconductor package and the outer surface of the second lead of the second semiconductor package by die attach material, for example soft solder or a polymer-based electrically conductive adhesive, e.g. an epoxy resin.

In other embodiments, the outer surface of the second lead of the first semiconductor package is attached and electrically connected to the outer surface of the second lead of the second semiconductor package by die attach material, for example soft solder or a polymer-based electrically conductive adhesive, e.g. an epoxy resin, which is in contact with both the outer surface of the second lead of the first semiconductor package and the outer surface of the second lead of the second semiconductor package.

The module according to any one of the embodiments described herein may be used such that the two semiconductor dies are electrically connected in parallel or such that the two semiconductor dies are electrically connected to from a bi-directional switch, e.g. a bi-directional switch having a common drain.

The module can be produced simply as two packages, which may be the same, can be mounted back-to-back. In some embodiments, the two packages are mounted back-to-back on opposing main surfaces of an electrically conductive plate.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1, which includes figures 1A to 1G, illustrates vertically mountable semiconductor modules according to various embodiments.
Figure 2, which includes figures 2A to 2D, illustrates a vertically mountable semiconductor module according to an embodiment.
Figure 3, which includes figures 3A and 3B, illustrates a semiconductor module according to an embodiment.
Figure 4 illustrates a circuit diagram which the module of figure 1 or figure 3 may be used.
Figure 5, which includes figures 5A and 5B, illustrates semiconductor modules according to two embodiments.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

In some embodiments, the semiconductor die comprises a vertical device, for example a vertical transistor device or a vertical diode. In this context, the term "vertical" or "vertical direction" is understood to mean a direction that runs generally perpendicular to the main surfaces of the semiconductor and runs in the thickness direction of the semiconductor material or semiconductor carrier.

In some embodiments, the transistor device is a MOSFET (Metal Oxide Semiconductor Field Effect Transistor) device, an insulated gate bipolar transistor (IGBT) device or a Bipolar Junction Transistor (BJT).

The electrodes or pads of the transistor device are referred to herein as source, drain and gate. As used herein, these terms also encompass the functionally equivalent pads of other types of transistor devices, such as an insulated gate bipolar transistor (IGBT). For example, as used herein, the term "source" encompasses not only a source of a MOSFET device and of a superjunction device but also an emitter of an insulator gate bipolar transistor (IGBT) device and an emitter of a Bipolar Junction Transistor (BJT) device, the term "drain" encompasses not only a drain of a MOSFET device or of a superjunction device but also a collector of an insulator gate bipolar transistor (IGBT) device and a collector of a BJT device, and the term "gate" encompasses not only a gate of a MOSFET device or of a superjunction device but also a gate of an insulator gate bipolar transistor (IGBT) device and a base of a BJT device.

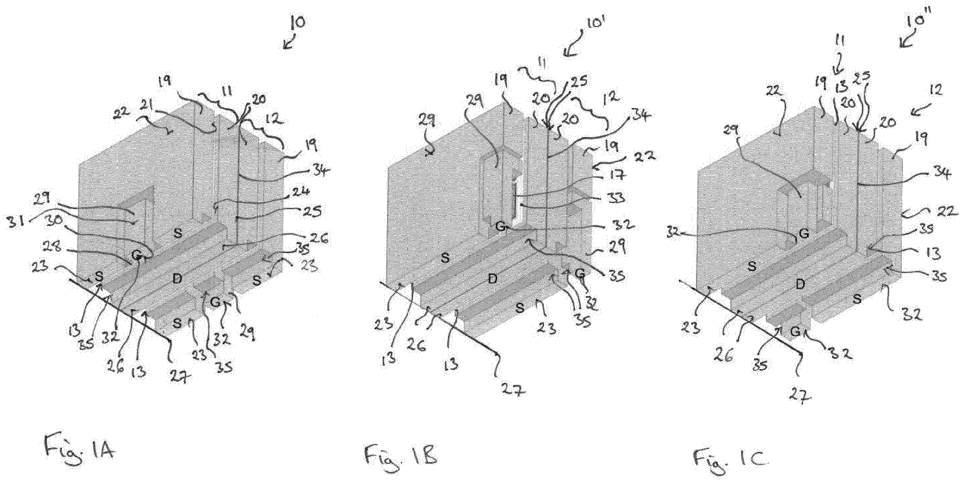

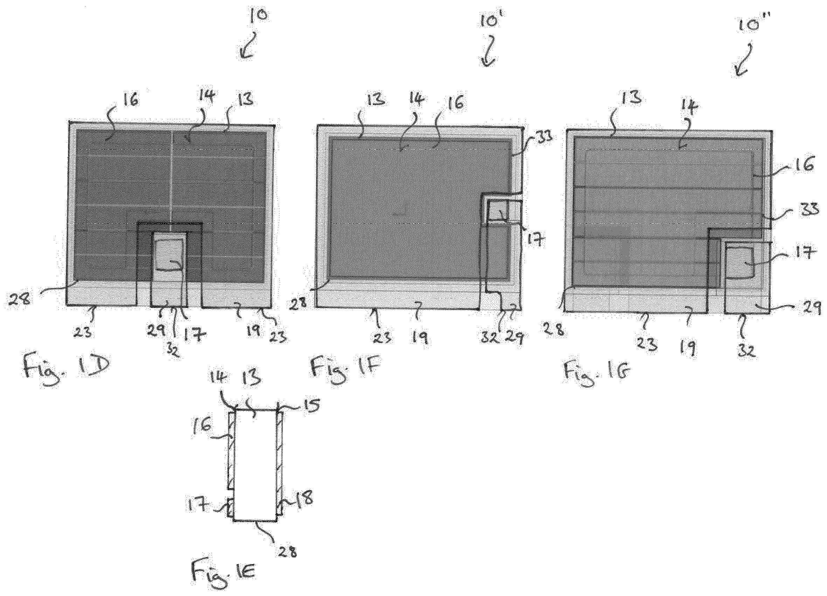

Figure 1 includes figures 1A to 1G and illustrates semiconductor modules according to various embodiments.

Figure 1A illustrates a perspective view of a semiconductor module 10 according to an embodiment. The semiconductor module 10 comprises a first package 11 and a second package 12. Each of the first and second packages 11, 12 comprises a semiconductor die 13 comprising a first main surface 14 and a second main surface 15 opposing the first main surface 14. The semiconductor die 13 is illustrated in figures 1D and 1E, whereby figure 1D illustrates a plan view of the first main surface 14 and figure 1E illustrates a cross-sectional view of the semiconductor die 13 of the first and second packages 11, 12 of the module 10. In this embodiment, the semiconductor die 13 comprises a transistor device and comprises a source pad 16 and a gate pad 17 arranged on the first main surface 14 and a drain pad 18 arranged on the second main surface 15.

Referring to figure 1A, each of the first and second packages 11, 12 of the module 10 further comprises a first lead 19 and the second lead 20. The first and second leads 19, 20 are planar. The first and second packages 11,12 of the semiconductor module 10 may have the same structure.

The first lead 19 comprises an inner surface 21, an outer surface 22 that opposes the inner surface 21 and a contact surface 23 that extends between the inner and outer surfaces 21, 22 and that is formed by a side face of the first lead 19. The inner surface 21 of the first lead 19 is attached, and electrically connected to, the source pad 16. The contact surface 23 of the first lead 19 extends substantially perpendicularly to the first main surface 14 of the semiconductor die 13. The second lead 20 also has an inner surface 24, an outer surface 25 which opposes the inner surface 24 and a contact surface 26 which extends between the inner surface 24 and outer surface 25 of the second lead 20 and which is formed by a side face of the second lead 20. The contact surface 26 of the second lead 20 extends substantially perpendicularly to the first main surface 14 of the semiconductor die 13 and also to the second main surface 15 of the semiconductor die 13.

The contact surfaces 23, 26 of the first and second leads 19, 20 are located in a contact plane 27 and each provide a contact surface of the semiconductor module 10. For example, the contact surfaces 23, 26 of the first and second leads 19, 20 of both of the first and second packages 11, 12 of the module 10 may be substantially coplanar.

The outer surface 25 of the second lead 20 of the first semiconductor package 11 is attached and electrically connected to the outer surface 25 of the second lead 20 of the second semiconductor package 12. Die attach material 34 may be used to attach the second leads 25 and, therefore, the first and second packages 11,12, to one another. Since the second lead 20 is electrically connected to the drain pad 18 within each of the packages 11, 12, the drain pads 18 of the semiconductor dies 13 of the first and second packages 11, 12 are electrically connected to one another. The contact surfaces 26 that are connected to the drain pads 18 are arranged at the centre of the module and extend over the entire breadth of the contact plane 17. The module 10 may be used in applications that require two transistor devices connected in a common drain arrangement, for example.

Referring to figure 1D, in this embodiment, the gate pad 17 is arranged laterally adjacent the lower side of 28 of the semiconductor die 13 that faces towards the contact plane 27 and in substantially the centre of the lower side 28 of the semiconductor die 13. The first and second semiconductor packages 11, 12 each include a third lead 29 which comprises an inner surface 30 which is attached, and electrically connected to, the gate pad 17, an outer surface 31 which opposes the inner side face 30 and a contact surface 32 which extends between the inner and outer surfaces 30, 31. The contact surface 32 of the third lead 29 is located in the contact plane 27 and may be substantially coplanar with the contact surfaces 23, 26 of the first and second leads 19, 20, respectively.

In this embodiment, the first lead 19 has an upturned U-type shape in plan view, i.e. the inner and outer surfaces 21, 22 have a U-shape, with the two legs of the U shape facing towards the contact plane 27. In this embodiment, the first lead 19 has two contact surfaces 23, one located on the lower surface of each leg. The third lead 29 that is connected to the gate pad 17 is arranged in the open side of the U-shape and is surrounded on three sides by the first lead 19. The contact surface 32 for the gate pad 17 is aligned in a row with two contact surfaces 23 of the first lead 19 and is arranged intermediate the breadth of the module 10 and at one side face of the module 10.

The first leads 19 of the first and second semiconductor packages 11, 12 and their respective contact surface 23 are arranged at the opposing sides of the contact plane 27 and opposing sides of the module 10. Similarly, the third leads 29 of the first and second semiconductor packages 11, 12 and their respective contact surface 32 are arranged at the opposing sides of the contact plane 27 and opposing sides of the module 10. The contact surfaces 26 of the second lead 20 are arranged towards the centre of the module 10 and extend over the entire breadth of the module 20. In this embodiment, the module 10 has a mirror symmetrical arrangement about a central plane of the module 10 that extends parallel to the first main surface 14 of the semiconductor die 13 and is located between the two second leads 20.

In some embodiments, the inner surface 21 of the first lead, the inner surface 24 of the second lead 20 and the inner surface 30 of the third lead 29 each include a recess 35 located in the edge formed between the inner surface and the contact surface of that lead. Consequently, the width of the contact surface 23, 26, 32, respectively, is less than the thickness of the section of the respective leads 19, 20, 29 which is connected to the respective pad 16, 17, 18 on the semiconductor die 13. Thus, in each package 11, 12, the spacing between the contact surface 23 connected to the source pad 16 and the contact surface 26 connected to the drain pad 18 is greater than the spacing between the section of the inner surface 21, 24 of the first and second leads 19, 20, respectively, which is mounted on the opposing first and second main surfaces 14, 15 of the semiconductor die 13. This arrangement, i.e. the provision of the recesses 35, increases the creepage distance of the module 10 and may assist in improving the reliability of the module 10.

The module 10 has a general cuboid structure and has a footprint, which defined by the area occupied by the module 10 on the circuit board and which corresponds to the area of the contact plane. In some embodiments, the area of the footprint of the module 10 less than the area of the first and second main surfaces 14, 15 of the semiconductor die 13. Thus, by vertically mounting the module 10 such that the first main surface 14 and second main surface 15 of the semiconductor die 13 is substantially perpendicular to the main surface of the circuit board and substantially perpendicular to the contact plane 27 and contact surfaces 23, 26, 32, the area occupied by the module 10 on the main surface of the board is reduced and space on the main surface of the circuit board can be saved.

Figure 1B illustrates a perspective view of a semiconductor module 10' according to an embodiment and figures 1F illustrates a plan view of the semiconductor die 13 of the first semiconductor package 11 of the module 10'. The module 10' illustrated in figure 1B differs from that illustrated in figure 1A by the position of the gate pad 17 on the first main surface 14 of the semiconductor die 13 and also in the position of the third lead 29, which is attached and electrically connected to the gate pad 17, of both of the semiconductor packages 11,12. In this embodiment, the gate pad 17 is positioned towards the edge of a side face 33 of the first main surface 14 of the semiconductor die 13, the side face 33 being located substantially perpendicularly to the contact plane 27 of the module 10' and forming an edge with the lower surface 28. The gate pad 17 is also positioned approximately in the centre of the height of the side face 33. In this embodiment, the first lead 19 has an L-shape in plan view and the third lead 29 is positioned in one corner of the side face of the module 10' such that it is surrounded on only two sides of the gate pad 29 by the first lead 19. In this embodiment, a single source contact surface 23 is provided for each package 11, 12.

The semiconductor die 13 of the first package 11 has a gate pad 17 on the first main surface 14 which is also positioned adjacent a side face 33, which is substantially perpendicular to the contact plane 29 and intermediate the height of the side face 33 but which is positioned. The gate pad 17 of the semiconductor die 13 of the second package 12 is, however, located adjacent the opposing side face such that in the module 10', the gate pads 17 of the first and second packages 11, 12 have a mirror symmetrical arrangement about a central plane of the module 10' that extends parallel to the first and second mains surfaces 14, 15 of the semiconductor dies 13. In this embodiment, the two gate contact surfaces 32 are arranged at a common side of the module 10'. The third leads 29 of the module 10' are arranged opposing corners of the contact plane 29 and adjacent a common side of the contact plane 29.

Referring to figures 1C and 1G, figure 1C illustrates a perspective view of a semiconductor module 10" which has a first and second semiconductor package 11, 12 and figure 1G illustrates a plan view of the first main side 14 of the semiconductor die 13 of each of the semiconductor packages 11, 12. The semiconductor die 13 included in each of the first and second packages 11, 12 of the semiconductor module 10 " differs from that illustrated in figures 1D and 1F in that the gate pad 17 is positioned in a corner of the first main surface 14 and in the corner between the side face 28 which faces towards the contact layer 29 and the side face 33 which extends substantially perpendicular to the contact plane 27. In this embodiment, the first lead 19 also has an L-shape in plan view and laterally surrounds the third lead 28 on two sides only and the third lead 29 is positioned at a corner of contact plane 29.

In this embodiment, the first and second semiconductor packages 11,12 have the same structure. In the module 10", the first and second packages 11, 12 are connected by attaching the outer surface 25 of the second leads 20 to one another, and the gate pad 17 of the semiconductor die 13 of the first and second packages 11, 12 and, consequently, the gate leads 29 are arranged at diagonally opposing corners of the contact plane 29 and therefore at diagonally opposing corners of the side faces of the module 10".

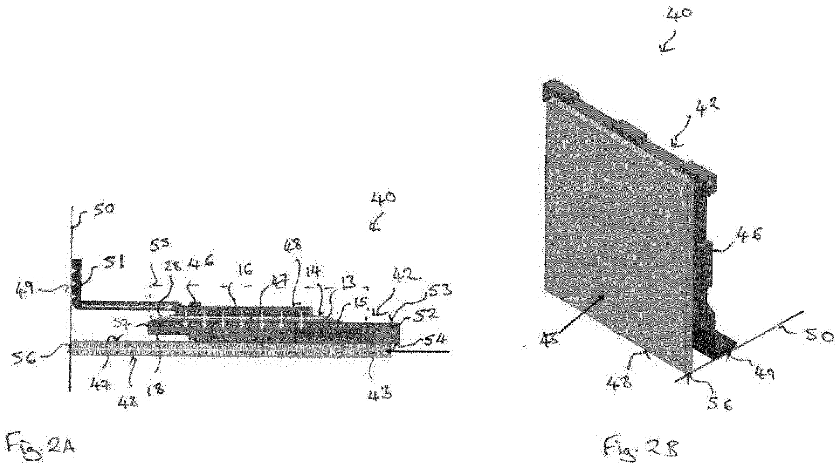

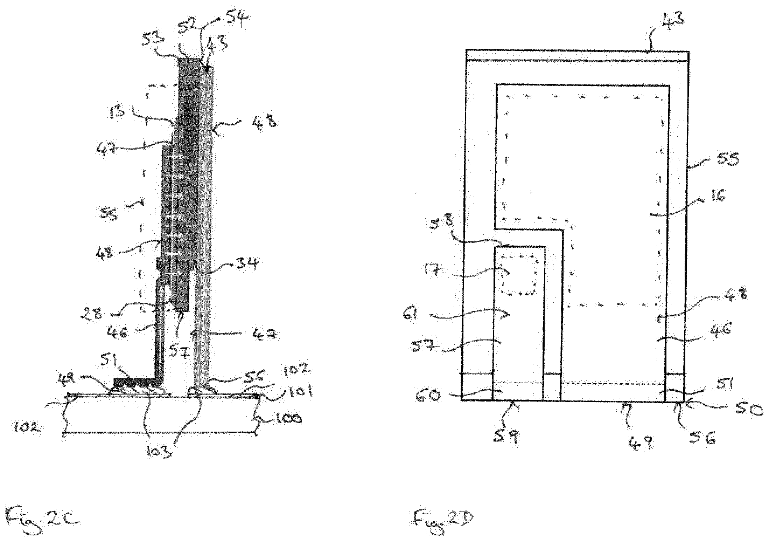

Figure 2 includes figures 2A to 2E. Figure 2A illustrates a side view of a vertically mountable semiconductor module 40 according to an embodiment, figure 2B a perspective view of the semiconductor module 40 in the vertically mountable position, figure 2C a side view of the semiconductor module 40 mounted on a circuit board 100, figure 2D a side view of the semiconductor module 40.

The semiconductor module 40 comprises a semiconductor package 42 and an electrically conductive plate 43. The semiconductor package 42 may have different forms and comprises at least one semiconductor die and one or more leads which are electrically connected to the semiconductor die. The electrically conductive plate 43 comprises a first main surface 47 and a second main surface 48 which opposes the first main surface 47. The laterally conductive plate 43 may be formed of copper, for example. The plate 43 is planar and rectangular in this embodiment.

The semiconductor package 42 comprises a semiconductor die 13 comprising a first main surface 14 and a second main surface 15 that opposes the first main surface 14, a first power pad 17 on the first main surface 14 and the second power pad 18 on the second main surface 15. In some embodiments, the semiconductor die 13 comprises a transistor device and further comprises a control pad 17 on the first main surface 14. In embodiments in which the semiconductor die 13 comprises a transistor device, the first power pad 16 may be a source pad and the second power pad 18 may be the drain pad. The semiconductor die 13 may be the die shown and described with reference to any one of figures 1D to 1G.

The semiconductor package 43 further comprises a first lead 46 comprising an inner surface 47, an outer surface 48 which opposes the inner surface 47, and at least one contact surface 49. In this embodiment, the inner surface 47 of the first lead 46 is attached, and electrically connected, to the first power pad 16 of the semiconductor die 13.

In other embodiments, which are not shown in figure 2, the first lead 46 is not attached to the first power pad 16 of the semiconductor die 13 directly but is electrically connected to the first power pad 16 by one or more additional electrical connectors such as one or more bond wires or a contact clip which extends between the first power pad 16 and the first lead 46. In these embodiments, the first lead 46 is positioned adjacent and spaced apart from the side face 28 of the semiconductor die 13.

The at least one contact surface 49 of the first lead 46 extends substantially perpendicularly to the first main surface 14 of the semiconductor die 13 and is arranged in a contact plane 50 of the semiconductor module 40.

In some embodiments, the first lead 46 has an L-shape in plan view with the upright of the L providing a die support section whose the inner surface 47 which is attached to the first power pad 16. The lower portion of the L-shape comprises a foot 51 having a lower surface which provides the contact surface 49. The foot 51 of the first lead 46 extends away from the first main surface 14 of the semiconductor die 13. The first lead 46 may be bent to form the foot 51. The lower surface of the foot 51 and the contact surface 49 is located in the contact plane 50 of the module 40.

The semiconductor package 42 further comprises a second lead 52 which has an inner surface 53 and an outer surface 54 which opposes the inner surface 53. The inner surface 53 of the second lead 52 is attached to the second power pad 18 arranged on the second main surface 15 of the semiconductor die 13. The semiconductor die 13 is arranged in a stack and between the first and second leads 46, 52.

The semiconductor package 42 further comprises a mold compound 55 which covers at least part of the semiconductor die 13 and at least part of the first and second leads 46, 52. In particular, at least part of the inner surface 47 of the first lead 46 and at least a part of an inner surface 53 of the second lead 52 are covered by the mold compound 55. The outer surface 54 of the second lead 52 is exposed from the mold compound 55 and is attached to the first main surface 47 of the electrically conductive plate 43.

The electrically conductive plate 43 has a contact surface 56 which extends between the inner and outer surfaces 47, 48 and also extends substantially perpendicularly to the second main surface 15 and the first main surface 14 of the semiconductor die 13. The contact surface 56 of the plate 43 and the contact surface 49 of the first lead 46 are arranged in the contact plane 50 and may be substantially coplanar to one another. Each of the contact surfaces 49, 56 provides a contact surface of the semiconductor module 40. The contact plane 50 is spaced at a distance from the lower side face 57 of the second lead 52 and from the lower side face 28 of the semiconductor die 13 that faces towards the contact plane 50.

The electrically conductive plate 43 is electrically connected to the second power pad 18. Since the electrically conductive plate 43 protrudes over the lower side face 57 of the second lead 52, the side face of the plate 43 provides contact surface 56 positioned in the contact plane 50 which extends substantially perpendicularly to the first and second main surfaces 14. This arrangement of the plate 43 in the module 40 allows the semiconductor package 42 to be mounted vertically. The second lead 43 is therefore devoid of contact surfaces of the module 40 and provides only a portion of the internal redistribution structure between the semiconductor die 13 and the module contact surface 56 which is electrically connected to the second power pad 18 on the second main surface 15 of the semiconductor die 13 by way of the plate 43.

In some embodiments, the outer surface 48 of the first lead 46 may be covered by the mold compound 55. At least the contact surface 46 formed on the lower surface of the foot 51 of the first lead 46 remains exposed from the mold compound 55. In other embodiments, the entire outer surface 48 of the first lead 46 may be exposed from the mold compound 55.

Figure 2C illustrates a side view of the semiconductor module 40 mounted on the first main surface 101 of a circuit board 100. The circuit board 101 comprising contact pads 102 and traces on the first min surface 101. The contact pads 102 have a layout corresponding to the layout of the contact surfaces 49, 59, 56 of the semiconductor module 40. The contact surfaces 49, 59, 56 of the first lead 46 and the plate 43 are attached, and electrically connected to, their respective contact pad 102 on the circuit board 100 by conductive material 103, such as soft solder. The lower surface 26 of the semiconductor die 13 and the lower surface 27 of the second lead 52 of the semiconductor package 42 are arranged in a plane above and spaced apart from the first main surface 101 of the circuit board 100. The lower surface of the mold compound 55 is also spaced apart from the first main surface 101 of the circuit board 100. The first and second main surfaces 14, 15 of the semiconductor die 13 are arranged vertically and perpendicularly to the first main surface 101 of the circuit board in this mounted position.

Referring to the side view of figure 2D, in embodiments in which the semiconductor die 13 comprises a transistor device, the semiconductor package 42 further comprises a third lead 57 which has an inner surface 58 that is attached, and electrically connected, to the gate pad 17 of the semiconductor die 13. The third lead 57 is arranged laterally adjacent to and spaced apart from the first lead 46 and comprises a contact surface 59 which extends substantially perpendicularly to the first main surface 14 of the semiconductor die 13. The contact surface 59 of the third lead 57 is located in the contact plane 50 and may be substantially coplanar with the contact surface 49 of the first lead 46 and the contact surface 56 of the electrically conductive plate 43. The third lead 57 also has a foot 60 which extends away from the first main surface 14 of the semiconductor die 13 and whose lower surface provides the contact surface 59 of the third lead. The third lead 59 has an L-shape form in cross-section. An outer surface 61 of the third lead 57 that opposes the inner surface 58 is covered by the mold compound 55.

The shape of the first lead 46 and position of the third lead 57 and the contact surface 59 for the gate depends on the position of the gate pad 17 on the first major surface 14 of the semiconductor die 13. For example, the gate pad 17 may be positioned on the first major surface 14 according to any one of the arrangements shown in figures 1D, 1F and 1G. Consequently, the first lead 46 may have an upturned U-shape or an L-shape as shown in figures 1A to 1C. The first, second and third leads 46, 52, 57 may be attached to their respective pad 16, 17, 18 by die attach material. Similarly, the electrically conductive plate 43 may be attached to the outer surface 54 of the second lead 52 by die attach material 34. The die attach material may be soft solder, diffusion solder or electrically conductive adhesive.

The semiconductor package 42 may be a surface mount device (SMD) having standard package outline and an exposed die pad, the exposed die pad providing the exposed outer surface 54 of the second lead 52 onto which the electrically conductive plate 43 can be attached. Depending on the package type, the first and third leads 46, 57 may be modified, e.g. by bending to form a foot, to form the module 10, 10', 10" illustrated in figure 2.

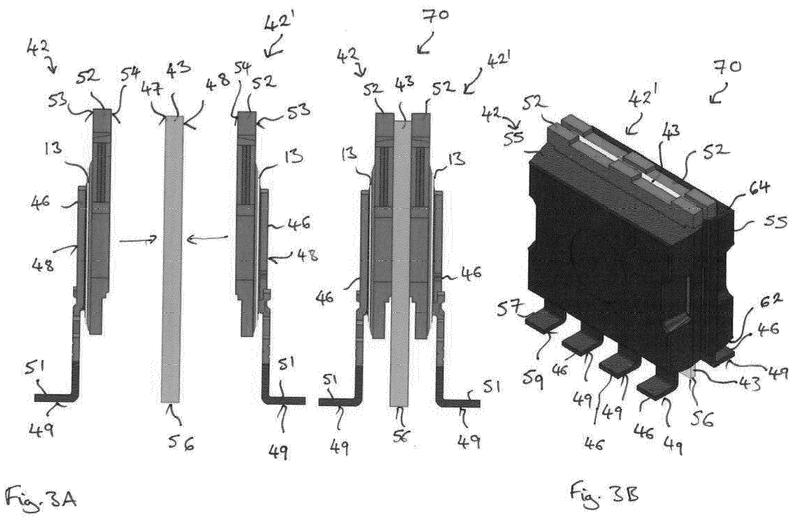

Figure 3, which includes figures 3A and 3B, illustrates a semiconductor module 70 according to another embodiment. The semiconductor module 70 comprises the semiconductor module 40 described with reference to and illustrated in figure 2 with its semiconductor package 42 and electrically conductive plate 43 and further comprises a further semiconductor package 42' which has the same structure as the semiconductor package 42. The further semiconductor package 42' is mounted on the second main surface 48 of the electrically conductive plate 43 such that the two semiconductor packages 42, 42' are attached to the opposing main surfaces 47, 48 of the electrically conductive plate 43. The plate 43 is positioned at the centre of sandwich type structure as can be seen in the cross-sectional view of figure 3A.

In the perspective view of figure 3B, the mold compound 55 is shown which covers the outer surfaces of the outwardly facing first leads 46, 46' and third leads 57, 57' of each of the semiconductor packages 42, 42'. The lower surface 62 of the mold compound 55 is spaced apart from the contact plane 50 such that the lower portion of the first and third leads 46, 57 and the lower portion of the electrically conductive plate 43 protrude from the lower surface 62 of the mold compound 55. In some embodiments, a distal portion 63, 63' of the second lead 57, 57' may protrude from, and be exposed by, the upper surface 64, 64' of the mold compound 55 of the respective package 42, 42'. This arrangement may assist in heat dissipation.

The semiconductor package 42, 42' may be formed by a standard, e.g. JEDEC, package, which may be modified by lead bending as in the embodiments of figures 2 and 3 for example, in which the lower surface of the die pad, i.e. the second surface 54 of the second lead 52, on which the second power pad, e.g. the drain pad, of the semiconductor die 13 is attached, is exposed from the mold compound 55. The leads 46, 52 of the standard package which are attached to the first power pad 16 and the control pad 17 may be bent to form the L-shape shown in figures 2 and 3 so as to allow vertical mounting of the semiconductor die 13 by way of the lower surface 49 of the foot 51 of the bent lead 46, 52. The electrically conductive plate 43 is larger than the die pad/second lead 52 and is positioned on the exposed surface 54 of the die pad/second lead 52 such that the contact surface 56 provided by the side face of the plate 43, which extends between the opposing first and second main surfaces 47, 48, is located in a common plane 50 with the lower surface 49 of the bent leads 46, 57. A standard package can therefore be modified to provide for vertical mounting by bending the leads attached to the pads 16, 17 on the first main surface 14 of the semiconductor die 13 and by attaching an additional electrical conductive plate 43 to the exposed lower surface of the die pad at the opposing side of the standard package.

In the embodiment of figure 3, the second power pad 18 of each of the packages 42, 42' is attached to the electrically conductive plate 43 and consequently to one another. In embodiments in which the semiconductor die 13 comprises a transistor device and the first power pad 16 is a source pad, the control pad 17 a gate pad and the second power pad 18 is a drain pad, this arrangement and the module 70 illustrated in figure 3 may be used in applications where two transistor devices have a common drain arrangement.

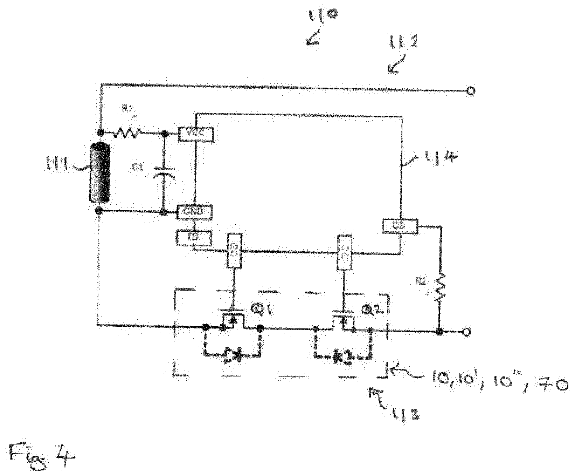

Figure 4 illustrates an example of a circuit 110 in which the semiconductor module 10, 10', 10", 70 may be used. Figure 4 illustrates a battery management system 110 for a battery 111 which comprises a battery protection circuit 112 and a battery protection switch 113 which comprises the semiconductor module 10, 10', 10", 70 including two transistor devices having a common drain configuration according to any one of the embodiments described herein.

The battery management system (BMS) 110 is used to protect the battery 111, typically a Lithium-ion battery, against faulty operation and to optimize the charging and discharging processes in order to avoid failures like thermal runaway, lithium plating, electrode decomposition, etc. A battery management system 110 is used to increase lifetime and efficiency of lithium batteries, also under stressful conditions. The battery protection circuit 112 disconnects the battery 111 from the load when a critical condition is observed, such as short circuit, undercharge, overcharge or overheating. Additionally, the battery protection circuit 112 manages current rushing into and out of the battery, such as during pre-charge or hotswap turn on.

The battery management system 110 comprises a battery protection switch 113 which conducts current in two directions and comprises two transistor devices Q1, Q2 in a common drain configuration and a controller IC 114 protects rechargeable batteries 111 from operating outside of the safe operating area, for example protects the battery 111 from overcharge, over-discharge, overcurrent, etc. Depending on the operational mode, Q1 and Q2 can be turned on / turned off individually.

During charging of the battery 114, both Q1 and Q2 of the battery protection switch 113 are turned on, or only Q2 is turned on which leads to increased losses due to current flow through body-diode of Q1.

During discharging of the battery 104, both Q1 and Q2 of the battery protection switch 113 are turned on, or only Q1 is turned on which leads to increased losses due to current flow through body-diode of Q2.

Overcharge protection is provided when both Q1 and Q2 are turned off. Q1 still allows current flow through body-diode therefore Q2 is used to block the current flow. Overcharge protection is also provided when both Q1 and Q2 are turned off. Q1 still allows current flow through body-diode therefore Q2 is used to block the current flow. Over-discharge protection is provided when both Q1 and Q2 are turned off. Q2 still allows current flow through body-diode therefore Q1 is used to block the current flow.

In another embodiment the module 10, 10', 10", 70 is used as a single switch, so that the two semiconductor dies 13 f the module 10, 10', 10", 70 are electrically connected in parallel. In this embodiment, the small footprint area of the module 10, 10', 10", 70 is useful. Furthermore, a reduced inductivity is provided due to the small inductance loop and footprint.

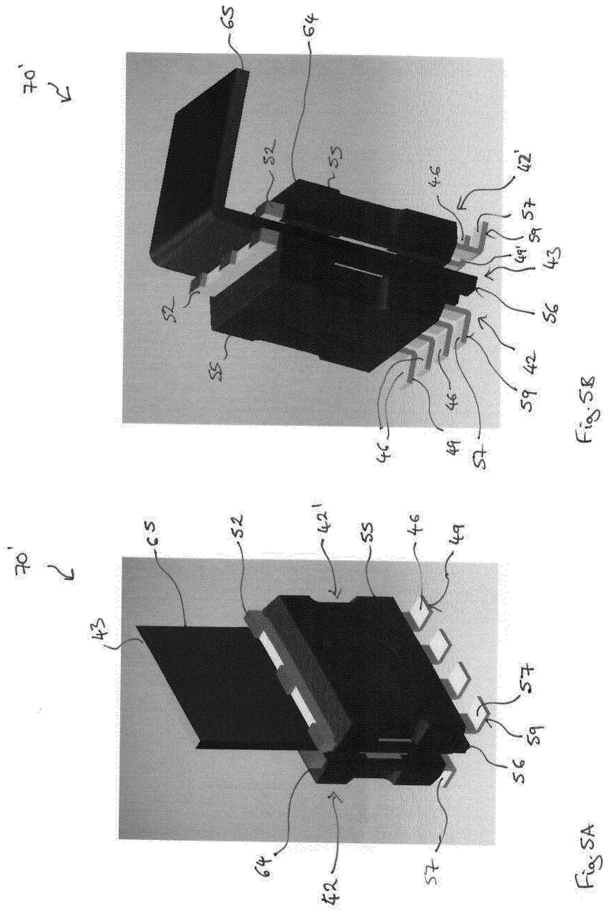

Figure 5 illustrates a further development of the semiconductor module 70 illustrated in figure 3. In the semiconductor module 70' illustrated in figure 5A, the electrically conductive plate 43 is sized and shaped such that its lower side face 56, which provides the contact surface 56 of the semiconductor package 70', is located in the contact plate 50 such that it protrudes above the upper surface 64 of the semiconductor module 70. A section 65 of the plate 43 protrudes above and is exposed from the mold compound 55 of the module 70 and is in contact with the environment so that it can dissipate heat generated during operation of the devices in the semiconductor dies 13 into the environment.

Figure 5B illustrates a variation of the semiconductor module 70' in which the exposed upper section 65 of the plate 43 which provides the heat dissipator is bent. For example, the exposed section 65 of the plate 43 may be bent through 90° so that the plate 43 has an upturned L-shape.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor module, comprising:
a semiconductor package and
an electrically conductive plate comprising a first main surface, a second main surface opposing the first main surface and a contact surface,
wherein the semiconductor package comprises:
a semiconductor die comprising opposing first and second main surfaces, a first power pad on the first main surface and a second power pad on the second main surface;
a first lead comprising an inner surface, an outer surface that opposes the inner surface and at least one contact surface, wherein the inner surface of the first lead is attached to the first power pad and the at least one contact surface of the first lead extends substantially perpendicularly to the first main surface of the semiconductor die;
a second lead comprising an inner surface that is attached to the second power pad and an outer surface that opposes the inner surface of the second lead;
a mold compound enclosing at least part of the semiconductor die and at least part of the first and second leads, wherein the outer surface of the second lead is exposed from the mold compound,
wherein the first main surface of the plate is attached to the outer surface of the second lead,
wherein the contact surface of the plate extends substantially perpendicularly to the second main surface of the semiconductor die and the at least one contact surface of the lead and the contact surface of the plate are located in a contact plane and each provide a contact surface of the semiconductor module.

2. A semiconductor module according to claim 1, wherein the second lead is devoid of contact surfaces of the module.

3. A semiconductor module according to claim 1 or claim 2, wherein the outer surface of the first lead is covered by the mold compound.

4. A semiconductor module according to any one of claims 1 to 3, wherein the first lead is a contact clip and extends into two or more legs, each leg comprising one contact surface of the lead that extends substantially perpendicularly to the first main surface of the semiconductor die.

5. A semiconductor module according to any one of claims 1 to 4, wherein the first lead and/or the plate is bent to form a foot.

6. A semiconductor module according to any one of claims 1 to 5, further comprising a third lead comprising an inner surface that is attached to a control pad of the semiconductor die and a contact surface that extends substantially perpendicularly to the first main surface of the semiconductor die, wherein the contact surface of the third lead is located in the contact plane.

7. A semiconductor module according to claim 6, wherein the first lead is U-shaped and the third lead is surrounded on three sides by the first lead, or the second lead is L-shaped and the third lead is located in a corner of the first main surface of the semiconductor die.

8. A semiconductor module according to any one of claims 1 to 7, wherein the plate extends over and protrudes above a side of the second lead that opposes the contact plane.

9. A semiconductor module according to any one of claims 1 to 8, further comprising a further semiconductor package, the further semiconductor package comprising:
a semiconductor die comprising opposing first and second main surfaces, a first power pad on the first main surface and a second power pad on the second main surface;
a first lead comprising an inner surface, an outer surface that opposes the inner surface and at least one first contact surface, wherein the inner surface is attached to the first power pad and the at least one first contact surface extends substantially perpendicularly to the first main surface of the semiconductor die;
a second lead comprising an inner surface that is attached to the second power pad and an outer surface that opposes the inner surface;
a mold compound enclosing at least part of the semiconductor die and at least part of the first and second leads, wherein the outer surface of the second lead is exposed from the mold compound, wherein the outer surface of the second lead of the further semiconductor package is attached to the second main surface of the plate.

10. A semiconductor module according to claim 9, wherein the semiconductor package and the further semiconductor package have a mirror symmetrical arrangement about a central plane of the plate that extends parallel to the first and second main surfaces of the respective semiconductor dies, or a third lead of the semiconductor package and a third lead of the further semiconductor package are arranged at opposing corners of the contact plane.

11. A semiconductor module, comprising:
first and second semiconductor packages, wherein each of the first and second semiconductor packages comprises:
a semiconductor die comprising opposing first and second main surfaces, a source pad and a gate pad on the first main surface and a drain pad on the second main surface;
a first lead comprising an inner surface, an outer surface that opposes the inner surface and a contact surface extending between the inner and outer surfaces, wherein the inner surface of the first lead is attached to the source pad and the contact surface of the first lead extends substantially perpendicularly to the first main surface of the semiconductor die;
a second lead comprising an inner surface, an outer surface that opposes the inner surface and a contact surface extending between the inner and outer surfaces, wherein the inner surface of the second lead is attached to the drain pad and the contact surface of the second lead extends substantially perpendicularly to the first main surface of the semiconductor die,
wherein the contact surfaces of the first and second leads are located in a contact plane and each provide a contact surface of the semiconductor module,
wherein the outer surface of the second lead of the first semiconductor package is attached and electrically connected to the outer surface of the second lead of the second semiconductor package.

12. A semiconductor module according to claim 11, wherein each of the first and second semiconductor packages further comprises a third lead comprising an inner surface that is attached to the control pad on the first main surface of the semiconductor die and a contact surface that extends substantially perpendicularly to the first main surface of the semiconductor die, wherein the contact surface of the third lead is located in the contact plane.

13. A semiconductor module according to claim 27, wherein the first lead is U-shaped and the third lead is surrounded on three sides by the first lead, or the second lead is L-shaped and the third lead is located in a corner of the first main surface of the semiconductor die.

14. A semiconductor module according to any one of claims 11 to 13, wherein the first and second semiconductor packages have a mirror symmetrical arrangement about a central plane of the module that extends parallel to the first and second main surfaces of the respective semiconductor dies.

15. A semiconductor module according to any one of claims 11 to 14, wherein the third lead of the first semiconductor package and the third lead of the second semiconductor package are arranged at opposing corners of the contact plane.
